# EUROPÄISCHE PATENTSCHRIFT

(11) **EP 0 290 080 B1**
(45) Veröffentlichungstag und Bekanntmachung des Hinweises auf die Patenterteilung: **10.07.1996**
(21) Anmeldenummer: 88200795.8
(22) Anmeldetag: 26.04.1988
(51) Int. Cl.: H03G 1/00, H03G 1/04

(54) **Schaltungsanordnung zum Verstärken eines Fernsehsignals**
Television signal amplifying circuitry
Circuit d'amplification d'un signal de télévision

(30) Priorität: 02.05.1987 DE 3714643
(43) Veröffentlichungstag der Anmeldung: 09.11.1988
(73) Patentinhaber: Philips Patentverwaltung GmbH, 22335 Hamburg (DE); Philips Electronics N.V., 5621 BA Eindhoven (NL)
(72) Erfinder: Brilka, Joachim, D-2000 Hamburg 70 (DE)
(74) Vertreter: Peters, Carl Heinrich, Dipl.-Ing.

(56) Entgegenhaltungen:
- US-A- 3 434 069
- US-A- 4 205 276
- ELEKTRONIK, Band 18, Nr. 12, Dezember 1969, Seiten 371-374; G. BUSSE: "Statik und Dynamik unsymmetrisch angesteuerter Differenzverstärker"
- P. HOROWITZ et al.: "The Art of Electronics", Erste Auflage 1980, Seite 72, Cambridge University Press, Cambridge, GB

## Beschreibung

Die Erfindung bezieht sich auf eine Schaltungsanordnung zum Verstärken eines Fernsehsignals mit einem zwischen einem Eingang mit zwei Eingangsanschlüssen und einem Ausgang angeordneten Differenzverstärker mit zwei emittergekoppelten Transistoren, deren Basisanschlüsse mit den Eingangsanschlüssen gekoppelt sind und von deren Kollektoranschlüssen das Fernsehsignal in verstärkter Form dem Ausgang zuführbar ist, mit einer Kombination aus wenigstens einem in die Emitterzweige der Transistoren eingefügten ohmschen Widerstand und einem ohmschen Rückkopplungsnetzwerk zum Rückführen eines Signals vom Ausgang zu einem ersten der Eingangsanschlüsse, mit wenigstens einer Emitterfolgerstufe, über die das Fernsehsignal dem Eingang zugeleitet wird.

Derartige Schaltungsanordnungen werden insbesondere in integrierten Schaltkreisen, beispielsweise zum Verstärken eines Fernsehsignals im Basisband, eingesetzt. Diese integrierten Schaltkreise sind standardmäßig für eine Versorgungsspannung von 12 V ausgelegt und verstärken das Fernsehsignal auf einen Spannungshub von typischer Weise 1 bis 2 V. An solche Anordnungen werden hohe Anforderungen bezüglich des Verstärkungsfaktors, der Linearität und der Stabilität gestellt, ihr Aufbau muß in einem einfach zu handhabenden und damit preiswerten Herstellungsverfahren für integrierte Schaltkreise erfolgen, und die Schaltungsanordnungen müssen selbst auch einen möglichst einfachen und platzsparenden Aufbau haben. Bei den bekannten Schaltungsanordnungen werden diese Anforderungen dadurch erfüllt, daß der Spannungshub des Fernsehsignals klein gegenüber der Versorgungsspannung bleibt.

Zur Verringerung der Leistungsaufnahme von Fernsehempfängern und dergleichen ist erwünscht, die Versorgungsspannungen für darin enthaltene Schaltungsanordnungen zur Verarbeitung des Fernsehsignals auf einen Wert zu vermindern, der in der Größenordnung des Spannungshubs des Fernsehsignals liegt, insbesondere bei z.B. 5 V. Dadurch wird ein Batteriebetrieb der Fernsehempfänger ermöglicht.

Andererseits sind für bestimmte Signal-Übertragungseigenschaften bestimmte Ströme erforderlich, die zwecks Leistungsverminderung nicht beliebig verringert werden können. Es zeigt sich, daß die bisher verfolgten Schaltungskonzepte in diesem Fall nicht mehr die an die Verarbeitung des Fernsehsignals zu stellenden Anforderungen insbesondere bezüglich der Linearität und der Stabilität erfüllen.

In dem Aufsatz von G. Busse:"Statik und Dynamik unsymmetrisch angesteuerter Differenzverstärker", ELEKTRONIK, Band 18, Nr. 12, Dezember 1969, Seiten 371-374, werden unterschiedliche Differenzverstärkerschaltungen mit emittergekoppelten Transistoren beschrieben. Alle diese Differenzverstärkerschaltungen sind, wie in der Zusammenfassung dieses zweiteiligen Aufsatzes auf Seite 337 im Heft 11 der Zeitschrift "Elektronik" von 1969 ausdrücklich erwähnt ist, als Operations- oder Rechenverstärker mit diskreten Bauelementen individuell aufgebaut. Wie sich beispielsweise aus dem Bild 1 auf Seite 337 ergibt, sind die beschriebenen Differenzverstärker für eine Versorgungsspannung von je 10 Volt symmetrisch zu Masse ausgelegt. Diese Spannung ist noch höher als die vorstehend bereits erwähnte Versorgungsspannung von 12 Volt für die zum Stand der Technik gehörenden, integrierten Schaltkreise. Mit diesen hohen Versorgungsspannungen geht eine hochohmige Dimensionierung der in der bekannten Schaltungsanordnung verwendeten Widerstände einher. Versorgungsspannung und Widerstandsdimensionierung sind mit den verwendeten Transistoren abgestimmt. Diese Abstimmung berücksichtigt die nichtlinearen Kennlinien der verwendeten Transistoren so, daß die bekannten Kennlinienfelder in einer Weise auszusteuern sind, die einen wenigstens weitgehend linearen Betrieb der Differenzverstärker gewährleisten. Tatsächlich ist im obigen Aufsatz, Zusammenfassung, Seite 337, von strengen Forderungen an den zu erstellenden Verstärker die Rede.

Anhand der vorstehend genannten Kennlinienfelder ist erkennbar, daß für eine Mindestanforderung an die Linearität eines mit derartigen Transistoren aufgebauten Differenzverstärkers bestimmte Grenzen für die die Transistoren aussteuernden Ströme bzw. Spannungen nicht unterschritten werden dürfen. Dies führt gerade dann zu großen Schwierigkeiten, wenn die Forderung aufgestellt wird, daß eine Schaltungsanordnung mit einer niedrigen Versorgungsspannung zu schaffen ist. Mit dieser niedrigen Versorgungsspannung, die in die Größenordnung des Spannungshubs des zu verarbeitenden Signals (hier Fernsehsignal) gelangt, soll eine verringerte Leistungsaufnahme erreicht werden und insgesamt die Speisung aus einer Batterie oder dergleichen ermöglicht werden.

Eine Schaltungsanordnung der im obigen Aufsatz genannten Art läßt sich unter diesen Gesichtspunkten nicht mit einer derart (auf etwa 25%) verringerten Versorgungsspannung betreiben. Vielmehr sind für den erfolgreichen Entwurf einer mit wenigstens unvermindert hoher Linearität arbeitenden Verstärkerschaltung oder dergleichen bei einer derart geringen Versorgungsspannung nicht nur umfangreiche Neudimensionierungen, sondern völlig neue Schaltungskonzepte erforderlich.

Die Erfindung hat die Aufgabe, eine Schaltungsanordnung zum Verstärken eines Fernsehsignals zu schaffen, die mit dem vorgegebenen Herstellungsverfahren erstellt werden kann und dabei trotz niedriger Versorgungsspannung und hoher Aussteuerung durch das Fernsehsignal in hohem Maße linear und stabil arbeitet.

Die Aufgabe wird bei einer Schaltungsanordnung der eingangs genannten Art erfindungsgemäß durch die kennzeichnenden Merkmale des Hauptanspruchs gelöst.

Das eingangs genannte, bevorzugt zu verwendende Herstellungs-(Diffusions-)Verfahren zur Herstellung von integrierten Schaltkreisen auf einem Halbleiterplättchen zeichnet sich dadurch aus, daß bei der Diffusion Bauelemente mit geringen Schichtdicken entstehen. Es wird gewählt, um Bauelemente und Schaltungen mit guten Hochfrequenzeigenschaften zu erhalten, die insbesondere für die ZF-Signalverarbeitung in Fernseh-Empfangsanordnungen benötigt werden. Es zeigt sich, daß die damit erzeugten (bipolaren) Transistoren eine verhältnismäßig geringe "Early-Spannung" entsprechend einer verhältnismäßig hohen Abhängigkeit der Kollektorströme dieses Transistoren von ihren Kollektor-Emitter-Spannungen auch im Verstärkerbereich aufweisen. Dadurch werden insbesondere bei höheren Strom- bzw. Spannungshüben an den Transistoren nichtlineare Verzerrungen hervorgerufen, die sich besonders stark bei niedrigen Versorgungsspannungen und zugleich hohen Signal-Spannungshüben bemerkbar machen. Die Einhaltung der geforderten Linearität kann damit in erster Linie nicht durch die Dimensionierung bzw. Topologie der einzusetzenden Transistoren erfolgen. Durch die Maßnahmen nach der Erfindung wird der Einfluß dieser Nichtlinearitäten auf die Verstärkungscharakteristik soweit vermindert, daß die hohen Anforderungen an die Linearität bei der Verarbeitung des Fernsehsignals erfüllt werden können. Insbesondere wird dadurch eine Schaltungsanordnung zum Verstärken eines Fernsehsignals geschaffen, die über das gesamte vom Fernsehsignal beanspruchte Frequenzband eine gleichmäßig hohe Verstärkung sowie oberhalb dieses Frequenzbandes einen steilen Abfall der Amplituden-Frequenz-Charakteristik aufweist. Eine hohe Verstärkung des Nutzsignals wird so mit einer hohen Stabilität der über das ohmsche Rückkopplungsnetzwerk rückgekoppelten Schaltungsanordnung verbunden. Durch Verwenden eines rein ohmschen Rückkopplungsnetzwerks wird dabei eine geringe Phasendrehung zwischen dem Fernsehsignal am Eingang und dem Signal am Ausgang und damit eine hohe Stabilität erzielt.

Die Kombination des ohmschen Widerstands in den Emitterzweigen mit dem ohmschen Rückkopplungsnetzwerk ermöglicht zunächst eine Einstellung der Amplituden-Frequenz-Charakteristik der Schaltungsanordnung in ihren beiden Freiheitsgraden. Durch die Emitterwiderstände wird im wesentlichen der Abfall der Amplituden-Frequenz-Chakakteristik oberhalb des Frequenzbandes des Fernsehsignals und damit die Stabilität bestimmt, wohingegen das ohmsche Rückkopplungsnetzwerk im wesentlichen die Einstellung der Verstärkung innerhalb des Frequenzbandes des Fernsehsignals bedingt.

Das Fernsehsignal wird dem Eingang über wenigstens eine Emitterfolgerstufe zugeleitet. Dadurch wird eine Impedanzwandlung und Entkopplung von voraufgehenden, das Fernsehsignal liefernden Schaltungsteilen erreicht. Das ist insbesondere dann von Vorteil, wenn die erfindungsgemäße Schaltungsanordnung unmittelbar vom Ausgang eines Demodulators gespeist wird. Die Emitterfolgerstufen verhindern dann eine Rückwirkung auf den Demodulator und unterdrücken anderenfalls im Demodulator hervorgerufene Signalverzerrungen.

Die erfindungsgemäße Schaltungsanordnung mit einem Eingang mit zwei Eingangsanschlüssen, von denen ein erster mit dem Rückkopplungsnetzwerk verbunden ist, enthält ein ohmsches Kompenstionsnetzwerk zum Einspeisen eines Anteils des Signals vom Ausgang auf einen zweiten der Eingangsanschlüsse. Wenn von zwei Eingangsanschlüssen nur einer zwecks Rückkopplung mit dem Signal vom Ausgang beaufschlagt wird, liegen an ihnen unterschiedliche Spannungen, durch die die Schaltungsanordnung unterschiedlich ausgesteuert wird. Insbesondere werden dadurch mit den Eingangsanschlüssen verbundene Emitterfolgerstufen unterschiedlich ausgesteuert, so daß an ihnen nichtlineare Verzerrungen auftreten. Durch das ohmsche Kompensationsnetzwerk wird ein Anteil des Signals vom Ausgang der Schaltungsanordnung auch dem zweiten Eingangsanschluß und damit der zweiten mit ihm gekoppelten Emitterfolgerstufe zugeführt derart, daß die Emitterfolgerstufen gleichmäßig ausgesteuert werden. Ihre Aussteuerungsbereiche in den Kennlinienfeldern der sie bildenden Transistoren sind dann identisch, so daß übereinstimmende Strom- und Spannungsverläufe im gesamten durch das Fernsehsignal bedingten Aussteuerbereich erzielt werden können.

Die erfindungsgemäße Schaltungsanordnung weist eine sehr hohe Linearität auf, die sich in einer sehr geringen Amplituden- und Phasenverzerrung und somit einem sehr niedrigen Klirrfaktor bemerkbar macht. Damit sind bei niedriger Versorgungsspannung und dadurch bedingter niedriger Verlustleistung hohe Spannungshübe des Fernsehsignals am Ausgang erzielbar. Die Verstärkung im Frequenzband des Fernsehsignals ist in weiten Bereichen bei gleichbleibend guter Linearität frei wählbar. Die erfindungsgemäße Schaltungsanordnung weist dabei ein hohes Verstärkungs-Bandbreite-Produkt bei gleichzeitig guter Stabilität auf. Darüber hinaus ist ein sehr gleichmäßiger Verlauf der Amplituden-Frequenz-charakteristik im Frequenzband des Fernsehsignals gewährleistet.

Die Unteransprüche betreffen vorteilhafte Ausgestaltungen des Erfindungsgegenstandes, mit denen eine weitere Verringerung von Signalverzerrungen erzielt wird.

Einige Ausführungsbeispiele der Erfindung sind in der Zeichnung dargestellt und werden im nachfolgenden näher beschrieben. Es zeigen:
Fig. 1 ein Blockschaltbild eines ersten Beispiels einer erfindungsgemäßen Schaltungsanordnung, die als Video-Grundverstärker ausgeführt ist,
Fig. 2 ein Blockschaltbild eines weiteren Ausführungsbeispiels der Erfindung, das als Video-Nachverstärker ausgelegt ist,
Fig. 3 ein detailliertes Schaltbild des Ausführungsbeispiels nach Fig. 1,
Fig. 4 ein detailliertes Schaltbild des Ausführungsbeispiels nach Fig. 2.

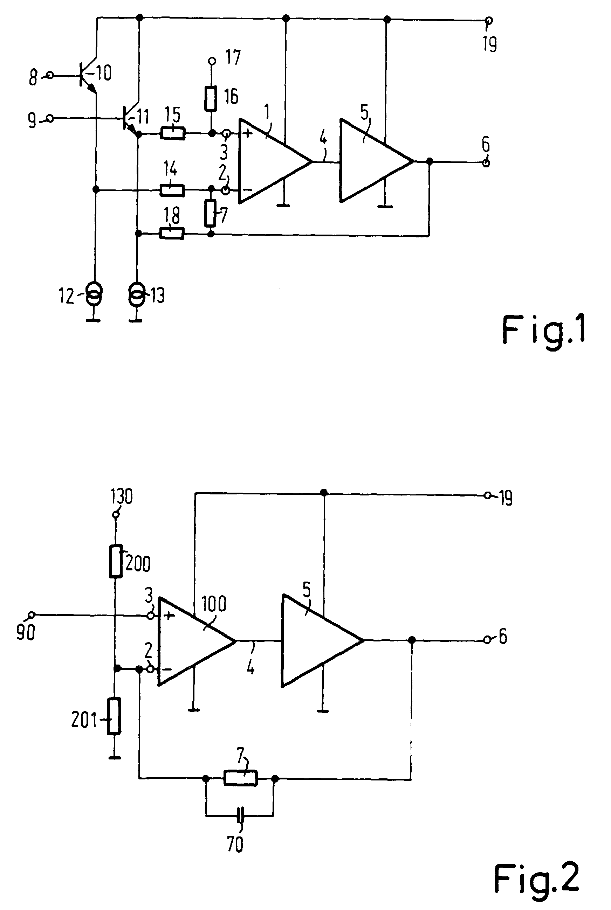

Im Blockschaltbild nach Fig. 1 ist mit 1 ein Differenzverstärker bezeichnet, dessen invertierender Eingang 2 und nichtinvertierender Eingang 3 zwei Eingangsanschlüsse eines Eingangs bilden. Der Differenzverstärker 1 gibt an einen Differenzverstärkerausgang 4 ein Signal ab, das der verstärkten Differenz der Spannungen an den Eingangsanschlüssen 2 und 3 entspricht. Dieses wird über einen Leistungsverstärker 5, der im Gegensatz zum Differenzverstärker 1 nur eine niedrige Spannungsverstärkung, vorzugsweise gleich 1, aufweist, und daher auch als Impedanzwandlerstufe fungiert, einem Ausgang 6 zugeleitet.

Der invertierende Eingang 2 des Differenzverstärkers 1 entsprechend dem ersten Eingangsanschluß ist über einen Rückkopplungswiderstand 7 mit dem Ausgang 6 verbunden, der ein im vorliegenden Fall sehr einfaches ohmsches Rückkopplungsnetzwerk bildet, durch das ein Signal vom Ausgang 6 zum Eingangsanschluß 2 zurückgeführt wird. Durch diese Rückkopplung wird die Verstärkung der den Differenzverstärker 1 und den Leistungsverstärker 5 umfassenden Schaltungsanordnung im Frequenzbereich des zu verstärkenden Fernsehsignals eingestellt.

Das zu verstärkende Fernsehsignal wird über zwei Zuführungen 8, 9, an die es von einer nicht dargestellten Anordnung, beispielsweise einem Demodulator, geliefert wird, über je eine Emitterfolgerstufe mit je einem Transistor 10, 11 und je einer Stromquelle 12, 13 sowie je einen Eingangswiderstand 14, 15 den Eingangsanschlüssen 2 bzw. 3 zugeleitet. Die Emitterfolgerstufen 10, 12 bzw. 11, 13 bilden für die Zuführungen 8 bzw. 9 hochohmige Belastungen und für die Eingangsanschlüsse 2 bzw. 3 niederohmige Signalquellen. Dadurch wird eine Rückwirkung auf der dargestellten Schaltungsanordnung vorgeschaltete Anordnungen vermieden. Die Emitterfolgerstufen 10, 12 und 11, 13 sind aus diesem Grunde auch nicht in die durch den Rückkopplungswiderstand 7 gebildete Rückkopplungsschleife einbezogen. Daher werden Nichtlinearitäten im Übertragungsverhalten der dargestellten Schaltungsanordnung, die durch die Transistoren 10, 11 der Emitterfolgerstufen hervorgerufen werden können, durch die Rückkopplungsschleife nicht ausgeglichen. Dafür dienen vielmehr zum einen die Stromquellen 12 bzw. 13, durch die den Transistoren 10 bzw. 11 feste Ströme eingeprägt werden, sowie eine geringe Aussteuerung der Transistoren 10, 11 an ihren Basisanschlüssen, wodurch verhindert wird, daß die Eingangskennlinien der Transistoren 10 bzw. 11 in merkbar nichtlineare Bereiche ausgesteuert werden.

Zum anderen entsteht jedoch eine nichtlineare Verzerrung der Spannungen an den Eingangsanschlüssen 2 und 3 durch die unterschiedliche, vom zu verstärkenden Fernsehsignal abhängige Belastung des ersten Eingangsanschlusses 2 durch das Signal am Ausgang 6 über den Rückkopplungswiderstand 7. Dadurch wird der Emitteranschluß des Transistors 10 der ersten Emitterfolgerstufe mit einem signalabhängigen Strom beaufschlagt, der über die Strom-Spannungs-Charakteristik des Transistors 10 am ersten Eingangsanschluß 2 eine Spannungsverzerrung hervorruft. Diese tritt am zweiten Eingangsanschluß 3, der über einen Vorwiderstand 16 mit dem Anschluß 17 einer Referenzspannungsquelle verbunden ist, die eine konstante Gleichspannung abgibt, nicht auf. Zum Unterdrücken derartiger Nichtlinearitäten ist in der Schaltungsanordnung nach Fig. 1 ein durch einen Kompensationswiderstand 18 gebildetes ohmsches Kompensationsnetzwerk zwischen dem Ausgang 6 und dem Emitteranschluß des Transistors 11 der zweiten Emitterfolgerstufe 11, 13 eingefügt. Dieser Kompensationswiderstand 18 ist derart bemessen, daß über ihn vom Signal am Ausgang 6 auf den Emitteranschluß des Transistors 11 der zweiten Emitterfolgerstufe 11, 13 der gleiche Einfluß ausgeübt wird wie auf den Emitteranschluß des Transistors 10 der ersten Emitterfolgerstufe 10, 12 über den Rückkopplungswiderstand 7 und den Eingangswiderstand 14. Damit kompensieren sich die durch die erste und die zweite Emitterfolgerstufe verursachten Nichtlinearitäten.

Die Emitterfolgerstufen 10, 12 bzw. 11, 13, der Differenzverstärker 1 und der Leistungsverstärker 5 werden über einen gemeinsamen Versorgungsspannungsanschluß 19 mit einer Gleichspannung versorgt.

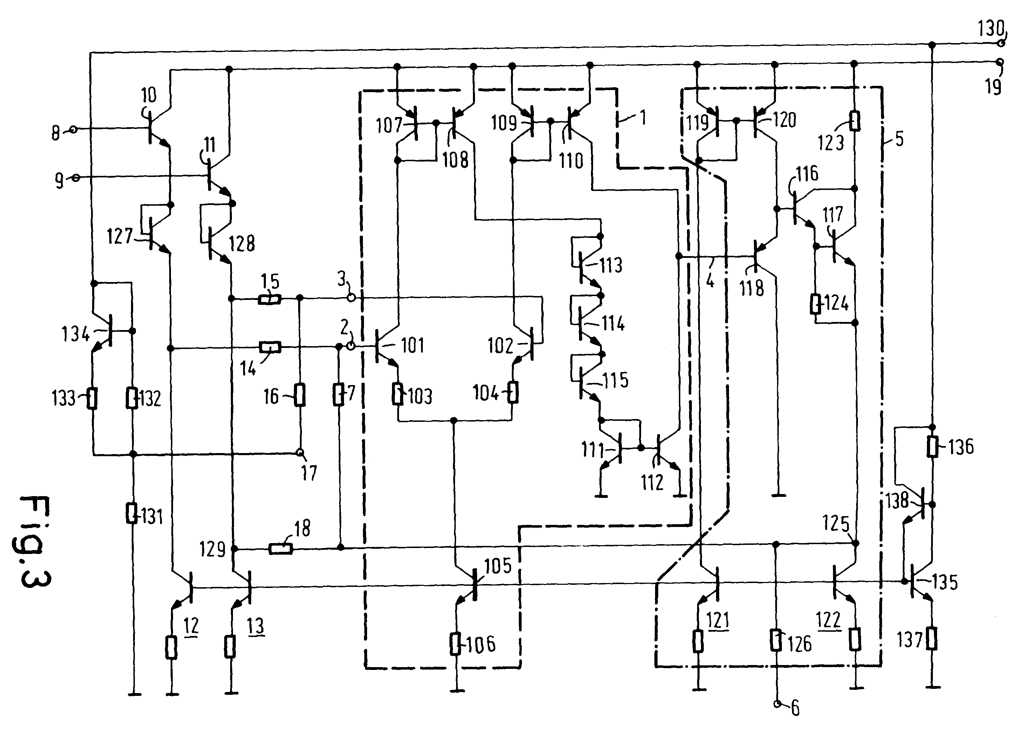

In Fig. 3 ist die Schaltungsanordnung nach Fig. 1 detaillierter ausgeführt, insbesondere sind Detailschaltungen für den Differenzverstärker 1 und den Leistungsverstärker 5 angegeben. Im übrigen sind in Fig. 1 bereits beschriebene Elemente wieder mit denselben Bezugszeichen versehen.

Der Differenzverstärker 1 umfaßt gemäß Fig. 3 zwei emittergekoppelte Transistoren 101, 102, deren Emitteranschlüsse über je einen Emitterwiderstand 103, 104 mit einer gemeinsamen Stromquelle, bestehend aus einem Stromquellentransistor 105 und einem Stromquellenwiderstand 106, verbunden sind. Über die mit den Eingangsanschlüssen 2 und 3 verbundenen Basisanschlüsse der Transistoren 101, 102 wird diesen das zu verstärkende Fernsehsignal zugeführt. Es tritt in verstärkter Form als Stromdifferenz an den Kollektoranschlüssen der Transistoren 101, 102 auf und wird durch eine Stromspiegelanordnung an den Differenzverstärkerausgang 4 übertragen.

Die Stromspiegelanordnung umfaßt drei Stromspiegel mit je zwei Transistoren 107, 108 bzw. 109, 110 bzw. 111, 112. Dabei übertragen ein erster und ein zweiter Stromspiegel 107, 108 bzw. 111, 112 den Kollektorstrom vom Kollektoranschluß des Transistors 101 und ein dritter Stromspiegel 109, 110 den Kollektorstrom vom Kollektoranschluß des Transistors 102 gegensinnig auf den Differenzverstärkerausgang 4 derart, daß sich bei identischen Kollektorströmen an den Transistoren 101, 102 die Stromsumme im Differenzverstärkerausgang 4 gerade zu Null aufhebt. Dort tritt somit nur ein Gegentaktsignal auf, während ein Gleichtaktsignal an den Eingangsanschlüssen 2, 3 im Differenzverstärker 1 unterdrückt wird.

Zwischen die Kollektoranschlüsse der Transistoren 108 und 111 des ersten und zweiten Stromspiegels ist eine Kette von drei als Dioden geschalteten Transistoren 113, 114, 115 eingefügt. Diese bewirken zwischen den Transistoren 108 und 111 eine konstante Potentialverschiebung entsprechend der an ihnen abfallenden Durchlaßspannungen der Basis-Emitter-Halbleiterübergänge. Dadurch wird vermieden, daß an den Transistoren 108 und 110 zu große Unterschiede der Kollektor-Emitter-Spannungen auftreten, die aufgrund der geringen "Early-Spannungen" zu Signalverzerrungen führen würden.

Durch die Emitterwiderstände 103, 104 wird eine interne Gegenkopplung des Differenzverstärkers 1 erzielt, die eine breitbandige Begrenzung der Leerlaufverstärkung des Differenzverstärkers 1 mit minimaler Phasendrehung des Signals am Differenzverstärkerausgang 4 gegenüber dem Signal am Eingang 2, 3 bewirkt. Die Emitterwiderstände 103, 104 werden so dimensioniert, daß die Leerlaufverstärkung des Differenzverstärkers 1 bei Erreichen einer Gesamtphasendrehung zwischen dem Ausgang 6 und dem Eingang 2, 3 von 180° (beim Übergang zu immer höheren Frequenzen des Fernsehsignals am Eingang) unter 0 dB gefallen und die Schaltungsanordnung damit stabil ist.

An den Differenzverstärkerausgang 4 schließt sich in der Schaltungsanordnung nach Fig. 3 der Leistungsverstärker 5 an, der im vorliegenden Beispiel im wesentlichen eine Darlington-Stufe aus zwei Transistoren 116, 117 umfaßt, die über einen PNP-Transistor 118 vom Differenzverstärkerausgang 4 angesteuert werden. Dem PNP-Transistor 118 wird über einen vierten Stromspiegel aus zwei Transistoren 119, 120 ein eingeprägter Strom von einer aus einem Transistor und einem zugehörigen Emitterwiderstand bestehenden Stromquelle 121 zugeführt. Eine entsprechend aufgebaute Stromquelle 122 speist den Laststrompfad des Transistors 117 der Darlington-Stufe und ist dazu mit diesem und einem Kollektor-Vorwiderstand 123,der als Schutzwiderstand für den Fall eines Kurzschlusses am Ausgang dient, zwischen dem Versorungsspannungsanschluß 19 und Masse in Reihe geschaltet. Außerdem ist die Basis-Emitter-Strecke des Transistors 117 durch einen Parallelwiderstand 124 als Gleichstromspeisung für den Transistor 116 überbrückt. Vom Verbindungspunkt 125 zwischen dem Transistor 117 und der Stromquelle 122 wird das verstärkte Fernsehsignal über einen Ausgangswiderstand 126 dem Ausgang 6 zugeleitet.

Vom Verbindungspunkt 125 ist außerdem der Rückkopplungswiderstand 7 an den ersten Eingangsanschluß 2 am invertierenden Eingang des Differenzverstärkers 1 geführt. Durch Wahl der Größe des Rückkopplungswiderstands 7 wird die Verstärkung der gesamten Schaltungsanordnung zwischen dem Eingang 2, 3 und dem Ausgang 6 eingestellt. Im wesentlichen wird dadurch die Verstärkung im Frequenzband des zu verstärkenden Fernsehsignals eingestellt, während der Abfall der AmplitudenFrequenz-Charakteristik zu höheren Frequenzen hin durch den Rückkopplungswiderstand 7 im wesentlichen unbeeinflußt bleibt.

Das zu verstärkende Fernsehsignal wird von den Zuführungen 8, 9 über die beiden Transistoren 10, 11 sowie in deren Emitterzweige als Dioden geschaltete Transistoren 127, 128 und die Eingangswiderstände 14, 15 den Eingangsanschlüssen 2 bzw. 3 zugeleitet. Die Transistoren 10, 11, 127, 128 bilden zusammen mit den Stromquellen 12, 13, die ebenfalls aus je einem Transistor mit Emitterwiderstand bestehen, zwei Emitterfolgerstufen zum rückwirkungsarmen Zuführen des zu verstärkenden Fernsehsignals an den Differenzverstärker 1. Die Transistoren 127, 128 dienen zur Potentialverschiebung zwischen den Emitteranschlüssen der Transistoren 10, 11 und den Eingangsanschlüssen 2, 3; zusammen mit den Basis-Emitter-Strecken der Transistoren 10, 11 rufen sie je einen Potentialsprung von zwei Basis-Emitter-Flußspannungen zwischen den Zuführungen 8 bzw. 9 und den Eingangsanschlüssen 2 bzw. 3 hervor.

Der zweite Eingangsanschluß 3 ist über den Vorwiderstand 16 an den Anschluß 17 einer Referenzspannungsquelle geführt, an dem eine im wesentlichen konstante Spannung anliegt. Dagegen wird dem ersten Eingangsanschluß 2 über den Rückkopplungswiderstand 7 das Signal vom Verbindungspunkt 125 mit relativ hoher Amplitude zugeführt, so daß an den Transistoren 10, 11, 127 und 128 unterschiedliche Stromaussteuerungen und damit Verzerrungen auftreten. Um diese auszuschließen, ist zwischen dem Verbindungspunkt 125 einerseits und dem Verbindungspunkt 129 zwischen dem Transistor 128 und der Stromquelle 13 andererseits der Kompensationswiderstand 18 eingefügt. Über ihn wird ein Teil des Signals vom Verbindungspunkt 125 bzw. vom Ausgang 6 auch den Transitoren 11, 128 zugeführt, so daß insgesamt eine verzerrungsfreie Aussteuerung erreicht werden kann.

Die am Anschluß 17 anliegende Spannung wird aus einer über einen Referenzspannungs-Speiseanschluß 130 zugeführten, stabilisierten Spannung mit Hilfe eines Spannungsteilers abgeleitet, der aus einer Reihenschaltung eines ersten Widerstands 131 mit der Parallelschaltung aus einem zweiten Widerstand 132 und einer Reihenschaltung eines dritten Widerstands 133 mit einem als Diode geschalteten Transistor 134 besteht. Der Transistor 134 bildet mit dem dritten Widerstand 133 einen Nebenschluß zu dem den Hauptanteil des im Spannungsteiler fließenden Stromes führenden zweiten Widerstand 132. Dieser Nebenschluß ist durch den Transistor 134 temperaturabhängig; und die so in der Spannung am Anschluß 17 erzeugte Temperaturabhängigkeit dient zur Kompensation des Temperaturgangs der Emitterfolgerstufen 10, 11, 127, 128.

Ein weiterer Spannungsteiler aus einem Transistor 135, einem zugehörigen Kollektor- und Emitterwiderstand 136 bzw. 137 sowie einem Paralleltransistor 138, dessen Emitteranschluß mit dem Basisanschluß des Transistors 135 und dessen Basisanschluß mit dem Kollektoranschluß des Transistors 135 verbunden ist und dessen Basis-Kollektor-Strecke parallel zum Kollektorwiderstand 136 liegt, ist zwischen den Referenzspannungs-Speiseanschluß 130 und Masse geschaltet. Am Basisanschluß des Transistors 135 wird eine Steuerspannung für die Stromquellen 12, 13, 121, 122 bzw. 105, 106 abgegriffen, deren Transistoren mit dem Transistor 135 je eine Stromspiegelanordnung bilden.

Der mit den Emitterfolgerstufen 10, 11, 12, 13 sowie dem Differenzverstärker 1 und dem Leistungsverstärker 5 zum Zuführen elektrischer Energie verbundene Versorgungsspannungsanschluß 19 ist vom Referenzspannungs-Speiseanschluß 130 getrennt ausgeführt, so daß gegebenenfalls durch hohe Belastung des Ausgangs 6 in den Versorgungsspannungsanschluß 19 eingestreute Spannungsstörungen keinen Einfluß auf die Referenzspannungen bzw. -ströme haben. Auch dies trägt zur verzerrungsarmen Signalverstärkung der beschriebenen Schaltungsanordnung bei. Außerdm wird am Versorgungsspannungsanschluß 19 zur Energieversorgung vorzugsweise eine Spannung bereitgestellt, die größer als die Referenzspannungen ist und aus der die letzteren abgeleitet werden können. Der Vorteil einer getrennten, vorzugsweise gesondert stabilisierten Spannung am Referenzspannungs-Speiseanschluß 130 liegt in einer verbesserten "Brumm"-Unterdrückung (Netzbrummen).

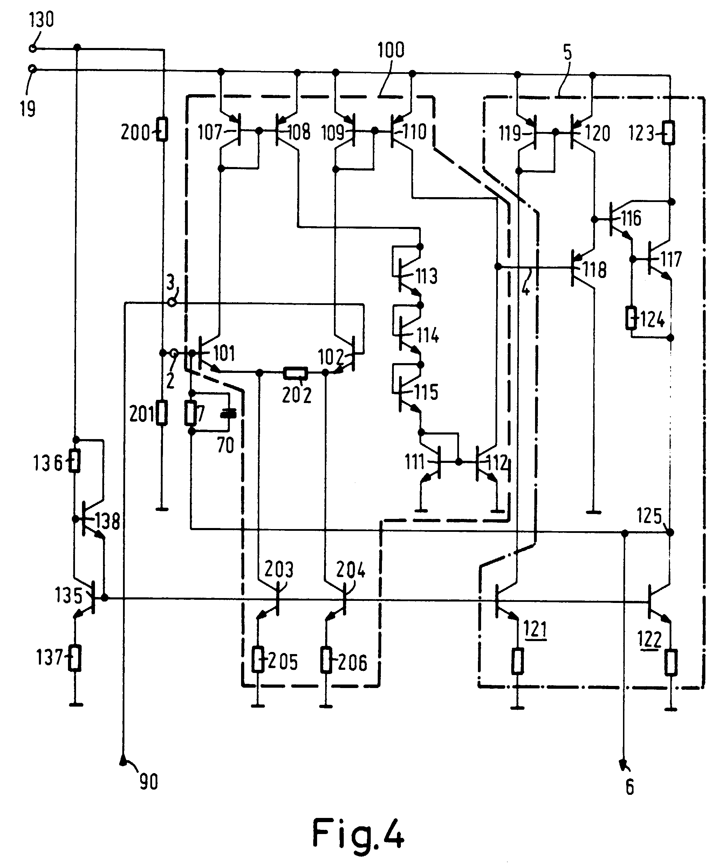

Fig. 2 und 4 zeigen ein weiteres Ausführungsbeispiel der Erfindung als Blockschaltbild bzw. detaillierte Schaltung. Mit Fig. 1 und 3 übereinstimmende Bestandteile sind wieder mit identischen Bezugszeichen versehen. Die Schaltungsanordnungen nach Fig. 2 und 4 stellen einen Video-Nachverstärker dar, der aus einem gegenüber dem Differenzverstärker 1 abgewandelten Differenzverstärker 100 sowie dem identisch übernommenen Leistungsverstärker 5 besteht. Dieser Video-Nachverstärker dient zur Nachverstärkung des vom Video-Grundverstärker nach Fig. 1 oder 3 gelieferten, verstärkten Fernsehsignals und wird an dessen Ausgang 6 bevorzugt über ein die modulierten Tonsignale unterdrükkendes Sperrfilter, eine sogenannte Tonträgerfalle, angeschlossen. Der Video-Nachverstärker nach Fig. 2 und 4 enthält dafür im Gegensatz zum Video-Grundverstärker einen Eintakt-Eingang 90, der unmittelbar an den zweiten Eingangsanschluß 3 angeschlossen ist, der durch den nichtinvertierenden Eingang des Differenzverstärkers 100 gebildet wird, und die Emitterfolgerstufen der Fig. 1 und 3 und alle damit in Zusammenhang stehenden Schaltungsteile entfallen beim Video-Nachverstärker. Dieser dient der Leistungsverstärkung, weist jedoch einen relativ geringen Spannungsverstärkungsfaktor auf. Die Anforderungen zur Erreichung von Linearität und Stabilität sind niedriger als bei den Anordnungen nach den Fig. 1 und 3. Parallel zum Rückkopplungswiderstand 7 kann daher ein Kondensator 70 geschaltet sein, der eine tiefpaßartige Rückkopplung mit im Vergleich zu den Anordnungen nach Fig. 1 und 3 stärkerer Phasendrehung bewirkt. Mit dieser Anordnung wird eine höhere Spannungsverstärkung bei gleichzeitiger Stabilität nicht mehr erreicht.

Die Anordnung nach Fig. 2 stellt damit eine auf geringere Anforderungen an ihre Übertragungseigenschaften, insbesondere an ihre Stabilität, ausgelegte Ausführungsform der Erfindung dar. Wie auch im Video-Grundverstärker wird beim Video-Nachverstärker nach Fig. 2 und 4 die Spannungsverstärkung, Linearität und Stabilität in erster Linie durch die Kombination einer internen Gegenkopplung und einer externen Rückkopplung erhalten. Der Kondensator 70 ist bevorzugt derart dimensioniert, daß er erst im Bereich der parasitären höheren Harmonischen zum Unterdrücken derselben wirksam wird, so daß er keinen kritischen Einfluß auf die Stabilität ausüben kann. Er weist insbesondere einen Kapazitätswert in der Größenordnung von 1 pF auf. Beim vorliegenden Herstellungsverfahren bedeutet dies eine Kondensatorfläche auf dem Halbleiterplättchen von ungefähr einem Tausendstel Quadratmillimeter. Die bei der Herstellung derartiger Flächen auftretenden Fertigungstoleranzen könnten zu Instabilitäten führen, wenn der Kondensator 70 einen entscheidenden Einfluß auf die Stabilität der Schaltungsanordnung hätte.

Im Video-Nachverstärker nach Fig. 2 ist der erste Eingangsanschluß 2 weiterhin mit dem Abgriff eines zwischen dem Referenzspannungs-Speiseanschluß 130 und Masse angeordneten Spannungsteilers aus zwei Widerständen 200, 201 verbunden zum Einstellen des Arbeitspunktes des Differenzverstärkers 100.

Im detaillierten Schaltbild nach Fig. 4 sind die Bauteile des Differenzverstärkers 100 durch eine gestrichelte Linie umrandet. Der Differenzverstärker 100 entspricht weitgehend dem Differenzverstärker 1 nach Fig. 3, lediglich die Kopplung der Emitteranschlüsse der Transistoren 101, 102 ist abgewandelt und erfolgt über einen gemeinsamen Emitterwiderstand 202. Jeder der Emitteranschlüsse ist außerdem mit einer Emitterstromquelle aus einem Stromquellentransistor 203 bzw. 204 und einem Stromquellenwiderstand 205 bzw. 206 verbunden. Die Funktionsweise dieser Anordnung entspricht im wesentlichen derjenigen der Emitterwiderstände 103, 104 und der gemeinsamen Stromquelle 105, 106 nach Fig. 3, die vorliegende Konfiguration ist jedoch für höhere Spannungsaussteuerungen geeignet, da zwischen den Emitteranschlüssen der Transistoren 101, 102 und den zugehörigen Emitterstromquellen kein zusätzlicher Gleichstrom-Spannungsabfall wie an den Emitterwiderständen 103, 104 auftritt.

Der Leistungsverstärker 5 ist mit demjenigen aus Fig. 3 identisch. Auch der weitere Spannungsteiler 135 bis 138 zur Steuerung der Stromquellentransistoren 203, 204 bzw. von 121 und 122 stimmt mit Fig. 3 überein. Dagegen ist der Verbindungspunkt 125 zwischen der Darlington-Stufe 116, 117 und der Stromquelle 122 unmittelbar mit dem Ausgang 6 verbunden, um einen niedrigen Ausgangswiderstand zu erhalten.

Eine Schaltungsanordnung gemäß Fig. 3 wurde beispielsweise für eine Verstärkung eines Fernsehsignals um 14 dB auf eine Amplitude von 1 V, eine Anordnung nach Fig. 4 für eine weitere Verstärkung des Fernsehsignals um 6 dB auf eine Amplitude der Ausgangsspannung von 2 V dimensioniert. Die Werte der Bauelemente im einzelnen sind für dieses Dimensionierungsbeispiel in der nachfolgenden Tabelle aufgeführt. Mit dieser Anordnung wurden Linearitätsabweichungen im Betrag der Verstärkung von weniger als 1 % und in der Phase von weniger als 1 ° sowie ein Klirrfaktor von weniger als 1 % erreicht. Die Verlustleistung beträgt typischer Weise etwa 13 mW.

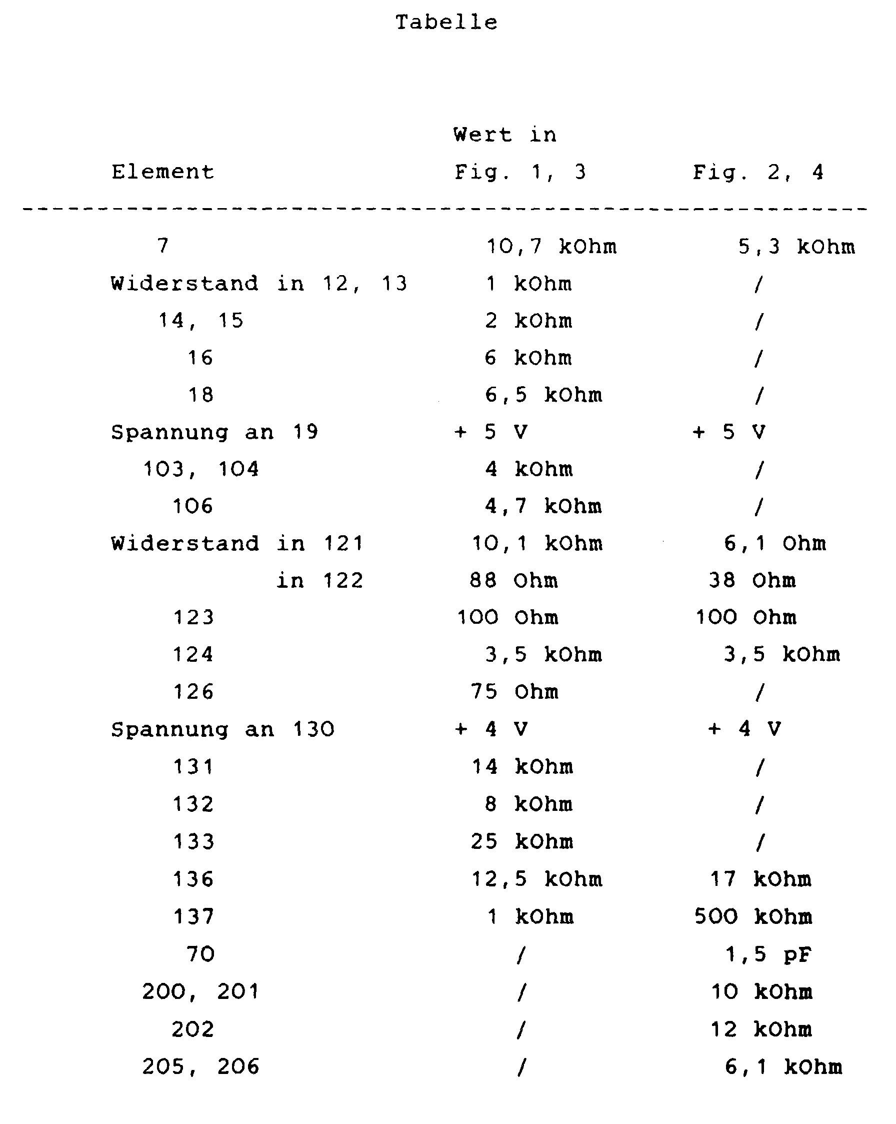

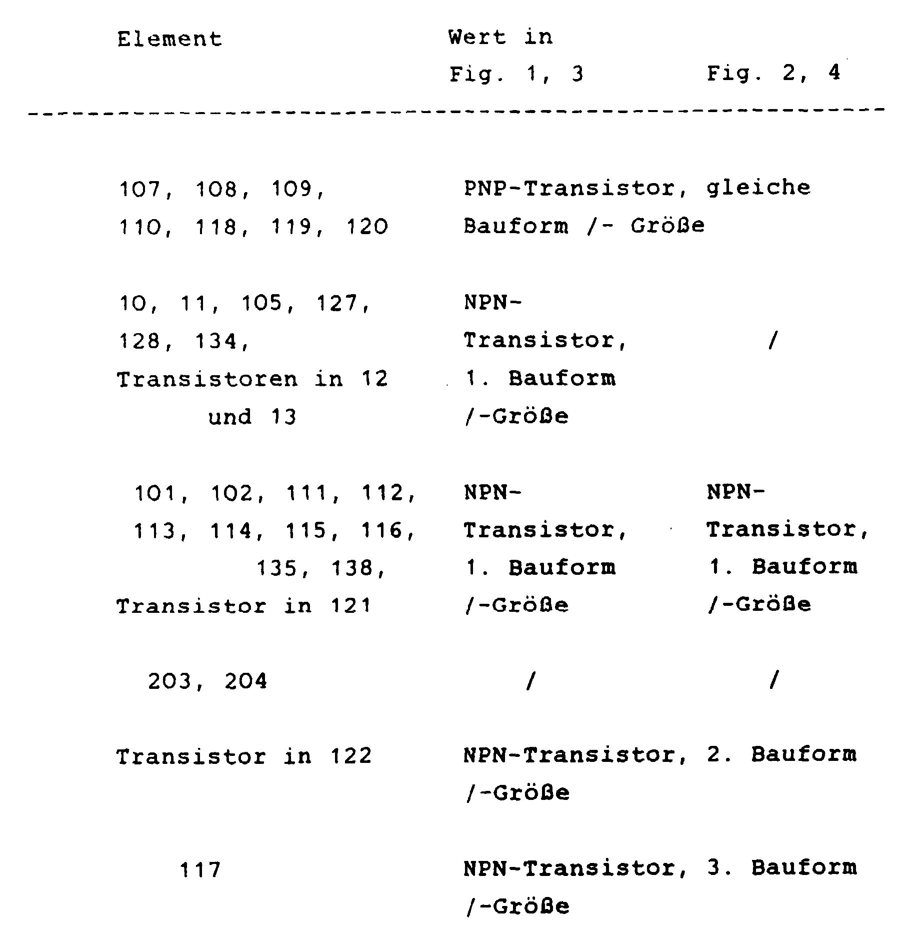

## Patentansprüche

1. Schaltungsanordnung zum Verstärken eines Fernsehsignals mit einem zwischen einem Eingang (2, 3) mit zwei Eingangsanschlüssen (2 und 3) und einem Ausgang (6) angeordneten Differenzverstärker (1) mit zwei emittergekoppelten Transistoren (101, 102), deren Basisanschlüsse mit den Eingangsanschlüssen gekoppelt sind und von deren Kollektoranschlüssen das Fernsehsignal in verstärkter Form dem Ausgang zuführbar ist, mit einer Kombination aus wenigstens einem in die Emitterzweige der Transistoren (101, 102) eingefügten ohmschen Widerstand (103, 104; 202) und einem ohmschen Rückkopplungsnetzwerk (7) zum Rückführen eines Signals vom Ausgang (6) zu einem ersten der Eingangsanschlüsse (2), mit wenigstens einer Emitterfolgerstufe (10, 127, 12 bzw. 11, 128, 13), über die das Fernsehsignal dem Eingang (2, 3) zugeleitet wird,
gekennzeichnet durch ein ohmsches Kompensationsnetzwerk (18) zum Einspeisen eines Anteils des Signals vom Ausgang (6) auf einen zweiten der Eingangsanschlüsse (3).

2. Schaltungsanordnung nach Anspruch 1,
dadurch gekennzeichnet, daß jede Emitterfolgerstufe (10, 127, 12 bzw. 11, 128, 13) je einen Transistor (10, 11) und je eine mit dessen Emitteranschluß verbundene Stromquelle (12, 13) umfaßt, durch die den Transistoren feste Ströme einprägbar sind.

3. Schaltungsanordnung nach Anspruch 1 oder 2,
dadurch gekennzeichnet, daß dem zweiten Eingangsanschluß (3) eine aus einer stabilisierten Spannung mit Hilfe eines Spannungsteilers ableitbare Spannung zuführbar ist, wobei der Spannungsteiler aus einer Reihenschaltung eines ersten Widerstands (131) mit der Parallelschaltung aus einem zweiten Widerstand (132) und einer Reihenschaltung eines dritten Widerstands (133) mit einem als Diode geschalteten Transistor (134) besteht.

4. Schaltungsanordnung nach Anspruch 3,
dadurch gekennzeichnet, daß aus der stabilisierten Spannung weiterhin über einen weiteren Spannungsteiler aus einem Transistor (135), einem zugehörigen Kollektor- und Emitterwiderstand (136 bzw. 137) sowie einem Paralleltransistor (138), dessen Emitteranschluß mit dem Basisanschluß des Transistors (135) und dessen Basisanschluß mit dem Kollektoranschluß des Transistors (135) verbunden ist und dessen Basis-Kollektor-Strecke parallel zum Kollektorwiderstand (136) liegt, eine Steuerspannung wenigstens für die Stromquellen (12, 13) der Emitterfolgerstufen (10, 12; 11, 13) vom Basisanschluß des Transistors (135) ableitbar ist.

5. Schaltungsanordnung nach Anspruch 3 oder 4,
gekennzeichnet durch einen Referenzspannungs-Speiseanschluß (130) zum Liefern der stabilisierten Spannung, der von einem mit den Emitterfolgerstufen (10, 11, 12, 13) sowie dem Differenzverstärker (1) zum Zuführen elektrischer Energie verbundenen Versorgungsspannungsanschluß (19) getrennt ausgeführt ist.

## Claims

1. A circuit arrangement for amplifying a television signal, comprising a differential amplifier (1) arranged between an input (2, 3) having two input terminals (2 and 3) and an output (6), which amplifier has two emitter-coupled transistors (101, 102) whose base terminals are coupled to the input terminals and the television signal can be applied in an amplified form from its collector terminals to the output, a combination of at least one ohmic resistor (103, 104; 202) arranged in the emitter branches of the transistors (101, 102), and a resistive feedback network (7) for feeding back a signal from the output (6) to a first input terminal (2), and at least one emitter-follower stage (10, 127, 12 and 11, 128, 13, respectively) via which the television signal is applied to the input (2, 3), characterized by a resistive compensation network (18) for applying a portion of the signal from the output (6) to a second input terminal (3).

2. A circuit arrangement as claimed in Claim 1, characterized in that each emitter-follower stage (10, 127, 12 and 11, 128, 13, respectively) comprises a transistor (10, 11) and a current source (12, 13) connected to its emitter terminal, by which current source fixed currents can be impressed on said transistors.

3. A circuit arrangement as claimed in Claim 1 or 2, characterized in that a voltage, which can be derived from a stabilized voltage by means of a voltage divider, can be applied to the second input terminal (3), said voltage divider consisting of a series arrangement of a first resistor (131) with the parallel circuit of a second resistor (132) and a series arrangement of a third resistor (133) with a diode-connected transistor (134).

4. A circuit arrangement as claimed in Claim 3, characterized in that from the stabilized voltage and via a further voltage divider consisting of a transistor (135), an associated collector and emitter resistor (136, 137, respectively) and a parallel transistor (138) whose emitter terminal is connected to the base terminal of the transistor (135) and whose base terminal is connected to the collector terminal of the transistor (135) and whose base-collector path is in parallel with the collector resistor (136), a control voltage for at least the current sources (12, 13) of the emitter-follower stages (10, 12; 11, 13) can be further derived from the base terminal of the transistor (135).

5. A circuit arrangement as claimed in Claim 3 or 4, characterized by a reference-voltage supply terminal (130) for supplying the stabilized voltage, which terminal is separated from a power supply terminal (19) connected to the emitter-follower stages (10, 11, 12, 13) and to the differential amplifier (1) for supplying electric energy.

## Revendications

1. Montage de circuit d'amplification d'un signal de télévision comprenant un amplificateur différentiel (1) agencé entre une entrée (2, 3) avec deux bornes d'entrée (2 et 3) et une sortie (6), ledit amplificateur différentiel comportant deux transistors (101, 102) couplés par les émetteurs, dont les bornes de bases sont couplées aux bornes d'entrée et dont les bornes de collecteurs sont destinées à acheminer le signal de télévision sous forme amplifiée à la sortie, une combinaison d'une résistance ohmique (103, 104; 202) insérée dans les branches d'émetteurs des transistors (101, 102) et d'un réseau de réaction ohmique (7) pour renvoyer un signal de la sortie (6) vers une première (2) des bornes d'entrée ainsi qu'au moins un étage émetteur-suiveur (10, 127, 12 ou 11, 128, 13), par lequel le signal de télévision est acheminé à l'entrée (2, 3), caractérisé par un réseau de compensation ohmique (18) pour réinjecter une partie du signal de la sortie (6) vers la deuxième (3) des bornes d'entrée.

2. Montage de circuit selon la revendication 1, caractérisé en ce que chaque étage émetteur-suiveur (10, 127, 12 ou 11, 128, 13) comprend respectivement un transistor (10, 11) et respectivement une source de courant (12, 13) connectée à sa borne d'émetteur, via laquelle des courants fixes peuvent être appliqués aux transistors.

3. Montage de circuit selon la revendication 1 ou 2, caractérisé en ce qu'une tension susceptible d'être dérivée d'une tension stabilisée à l'aide d'un diviseur de tension peut être acheminée à la deuxième borne d'entrée (3), le diviseur de tension étant constitué d'un montage en série d'une première résistance (131) avec le montage en parallèle d'une deuxième résistance (132) et d'un montage en série d'une troisième résistance (133) avec un transistor (134) connecté en diode.

4. Montage de circuit selon la revendication 3, caractérisé en ce qu'à partir de la tension stabilisée en outre via un autre diviseur de tension formé d'un transistor (135), d'une résistance de collecteur et d'émetteur associée (136 ou 137) ainsi que d'un transistor parallèle (138), dont la borne d'émetteur est connectée à la borne de base du transistor (135), dont la borne de base est connectée à la borne de collecteur du transistor (135) et dont le trajet base-collecteur est connecté en parallèle avec la résistance de collecteur (136), on peut dériver une tension de commande au moins pour les sources de courant (12, 13) des étages émetteurs-suiveurs (10, 12; 11, 13) de la borne de base du transistor (135).

5. Montage de circuit selon la revendication 3 ou 4, caractérisé par une borne d'alimentation de tension de référence (130) pour délivrer la tension stabilisée, qui est réalisée séparément par une borne de tension d'alimentation (19) connectée aux étages émetteurs-suiveurs (10, 11, 12, 13) ainsi qu'à l'amplificateur différentiel (1) pour acheminer l'énergie électrique.
